Europäisches Patentamt

European Patent Office

Office européen des brevets

(11) Veröffentlichungsnummer: **0 012 846**
A1

## (12) EUROPÄISCHE PATENTANMELDUNG

(21) Anmeldenummer: 79104621.2

(22) Anmeldetag: 21.11.79

(51) Int. Cl.³: **H 01 L 29/743**
H 01 L 23/56, H 02 M 1/08

(30) Priorität: 21.12.78 DE 2855265

(43) Veröffentlichungstag der Anmeldung:
09.07.80 Patentblatt 80/14

(84) Benannte Vertragsstaaten:
CH FR IT SE

(71) Anmelder: BROWN, BOVERI & CIE Aktiengesellschaft
Kallstadter Strasse 1
D-6800 Mannheim 41(DE)

(72) Erfinder: Weimann, Klaus, Dipl.-Ing.
Wierdenstrasse 19
D-6840 Lampertheim(DE)

(72) Erfinder: Kommissari, Karl, Dipl.-Ing.
Tilsiter Strasse 53
D-6944 Hemsbach(DE)

(74) Vertreter: Kempe, Wolfgang, Dr. et al,
c/o Brown, Boveri & Cie AG Postfach 351
D-6800 Mannheim 1(DE)

(54) Thyristor.

(57) Als Schutzbeschaltung ist auf der Oberseite des Thyristoraktivteils (1) eine dünne Widerstandsschicht (8) aufgebracht, die die Metallisierung (7.1) der Steuerelektrode und die Metallisierung (5) der Kathode verbindet. Auf die Widerstandsschicht (8) ist eine isolierende Zwischenschicht (9) und darüber eine Metallschicht (10) aufgebracht. Diese Metallschicht (10) bildet mit der isolierenden Zwischenschicht (9) und der Widerstandsschicht (8) einen Kondensator. Durch geeignete Verschaltung der Widerstandsschicht (8) und der Gegenelektrode (10) wird das zwischen Steuerelektrode (G) und Kathode (K) liegende RC-Glied gebildet.

Als Schutzbeschaltung ist ein Schichtschaltkreis (15,29,30) auf einem Keramikplättchen (14) ausgebildet, welches in die Kontaktplatte (12) des Thyristoraktivteils (1) eingebaut ist, oder in dem Thyristorgehäuse (20) eingebracht ist.

Fig. 2

Fig. 4

Fig. 5

BROWN , BOVERI & CIE AKTIENGESELLSCHAFT
Mannheim                              19. Dezember 1978
Mp.-Nr. 692/78                        ZFE/P3-Bi/dr


## Thyristor

Die Erfindung betrifft einen Thyristor mit Anode, Kathode und Steuerelektrode.

Leistungsthyristoren werden häufig in elektrische Anlagen eingesetzt, die erhebliche elektromagnetische Störfelder aufweisen. Ein typisches Beispiel hierfür sind Wechselrichter. Über die Steuerleitungen der Thyristoren können Störimpulse aufgenommen werden, die ein unkontrolliertes Schalten der Thyristoren verursachen. Um die Empfindlichkeit gegenüber solchen Störimpulsen zu verringern, kann man auf technologischem Wege die Zündwilligkeit der Thyristoren verschlechtern. Dadurch werden jedoch andere wichtige elektrische Parameter des Thyristors verschlechtert, z.B. das Einschaltverhalten, die Einschaltverluste, die Durchlaßverluste usw..

. Um Störimpulse vom Thyristor fernzuhalten, wird üblicherweise zwischen Steuerelektrode und Kathode eine Schutzbeschaltung aus einem Widerstand und einem parallelen Kondensator geschaltet.

Diese Beschaltung wird mit diskreten Bauelementen ausgeführt. Da sie möglichst nahe am Thyristor angeordnet werden muß, entstehen häufig Probleme wegen des fehlenden Platzes, besonders wenn mehrere Thyristoren mit zwischengeschalteten Kühlkörpern in Serie geschaltet werden müssen. Außerdem müssen diese RC-Glieder eine gewisse mechanische Stabilität aufweisen, insbesondere wenn die Anlage nicht ortsfest installiert wird.

Der vorliegenden Erfindung liegt die Aufgabe zugrunde, einen Thyristor mit Schutzbeschaltung zwischen Steuerelektrode und Kathode anzugeben, bei dem ke.ne Probleme mit dem Platzbedarf sowie der Stabilität und Vibrationsfestigkeit mehr auftreten.

Diese Aufgabe wird dadurch gelöst, daß die Schutzbeschaltung in den Thyristor integriert ist.

Auf diese Weise gelingt es, die Schutzbeschaltung, die aus einem Widerstand, einem Kondensator oder einer Parallelschaltung von beiden bestehen kann, optimal nahe an den Thyristor heranzubringen, wobei gleichzeitig praktisch kein zusätzlicher Platz gegenüber einem unbeschalteten Thyristor benötigt wird.

Gemäß einer ersten vorteilhaften Ausgestaltung ist die Schutzbeschaltung im Bereich der Steuerelektrode auf dem Thyristoraktivteil integriert. Dabei wird vorzugsweise eine Metallschicht im Bereich der Steuerelektrode auf den Thyristoraktivteil aufgebracht. Diese Metallschicht dient als Widerstandsschicht und verbindet die Metallisierungen von Steuerelektrode und Kathode, wie sie bei jedem herkömmlichen Thyristor vorhanden sind. Je nach Aufbau des Thyristoraktivteils kann die Metallschicht streifenförmig oder ganzflächig ausgebildet und partiell geätzt sein. Wichtig ist, daß sich der erforderliche Widerstandswert zwischen Steuerelektrode und Kathode einstellt.

Als besonders vorteilhaft hat es sich herausgestellt, wenn die Metallschicht aus einer im Vakuum aufgebrachten Chromschicht mit einer Dicke zwischen ca. 10 und ca. 500 nm besteht.

Um den Kondensator zu erzeugen, wird auf diese erste, als Widerstand dienende Metallschicht eine Isolierschicht und darüber eine weitere Metallschicht als Kondensatorgegenelektrode aufgebracht. Die Isolierschicht besteht vorzugsweise aus einem Siliziumoxid und die Gegenelektrode aus einer Chrom-Gold- oder einer Chrom-Nickel-Schicht.

Gemäß einer weiteren vorteilhaften Ausgestaltung der Erfindung ist die Schutzbeschaltung als Schichtschaltkreis auf einem Keramikplättchen ausgebildet, welches in die Kontaktplatte des Thyristoraktivteils eingebaut ist. Bei dieser Variante kann das RC-Glied getrennt vom eigentlichen Thyristoraktivteil in Dünn- oder Dickschichttechnik hergestellt werden. Dieser Schichtschaltkreis wird dann bei der Montage des Thyristors so mit den übrigen Teilen zusammengesetzt, daß sich die gewünschte RC-Beschaltung zwischen Steuerelektrode und Kathode ergibt.

Vorzugsweise wird der Schichtschaltkreis durch einen Steuerelektroden-Druckkontakt mit der Steuerelektrode und durch Federn und Kontaktplatte mit der Kathode verbunden. Hier wird die bewährte Druckkontaktierung auch zur Kontaktierung des Schichtschaltkreises eingesetzt, wodurch sich große Zuverlässigkeit und Haltbarkeit ergeben.

00128469

Gemäß einer dritten vorteilhaften Ausgestaltung der Erfindung ist die Schutzbeschaltung als Schichtschaltkreis auf einem Keramikplättchen ausgebildet, welches an dem Thyristorgehäuse im Bereich der inneren Steueranschlüsse befestigt und mit den Anschlüssen kontaktiert ist. Diese Variante wird mit Vorteil dann angewendet, wenn ein Aufsetzen des Keramikplättchens auf die Thyristorscheibe und die Druckkontaktierung aus bestimmten Gründen nicht anwendbar sein sollte.

Bei einer vierten vorteilhaften Ausgestaltung der Erfindung ist die Schutzbeschaltung als Schichtschaltkreis direkt auf der Innenwand des Thyristor-Keramikgehäuses aufgebracht. Diese Variante kommt somit ohne gesondertes Bauteil aus.

Bei einer fünften Ausgestaltung der Erfindung wird die RC-Schutzbeschaltung durch eine Diode ergänzt. Sie besteht aus einem separaten Diodenchip, der an der Innenwand des Thyristorgehäuse angebracht und entsprechend verschaltet wird.

Anhand der Zeichnung soll die Erfindung in Form von Ausführungsbeispielen näher erläutert werden.

Fig. 1 zeigt einen Thyristor mit einer Schutzbeschaltung zwischen Steuerelektrode und Kathode in Form eines parallelgeschalteten RC-Gliedes.

Fig. 2 zeigt als Querschnitt die Realisierung einer Schutzbeschaltung direkt auf den Aktivteil eines Thyristors.

Fig. 3 zeigt die Verteilung der Widerstände und Kapazitäten zwischen Steuerelektrode und Kathode bei einer Ausführung gemäß Fig. 2.

Fig. 4 zeigt als Querschnitt eine Schutzbeschaltung in Form eines Schichtschaltkreises auf einem Keramikträgerplättchen und seine Montage mittels Druckkontaktierung.

Fig. 5 zeigt als Querschnitt eine Schutzbeschaltung in Form eines Schichtschaltkreises, der direkt auf der Innenwand des Thyristorgehäuses aufgebracht ist.

Fig. 6 zeigt als Querschnitt eine Schutzbeschaltung in Form eines Schichtschaltkreises auf einem Keramikträgerplättchen mit einer zusätzlichen Diode, die direkt auf der Innenwand des Thyristorgehäuses aufgebracht sind.

Fig. 7 zeigt einen Thyristor mit einer Schutzbeschaltung zwischen Steuerelektrode und Kathode in Form eines parallelgeschalteten RC-Gliedes mit zusätzlicher Schutzdiode

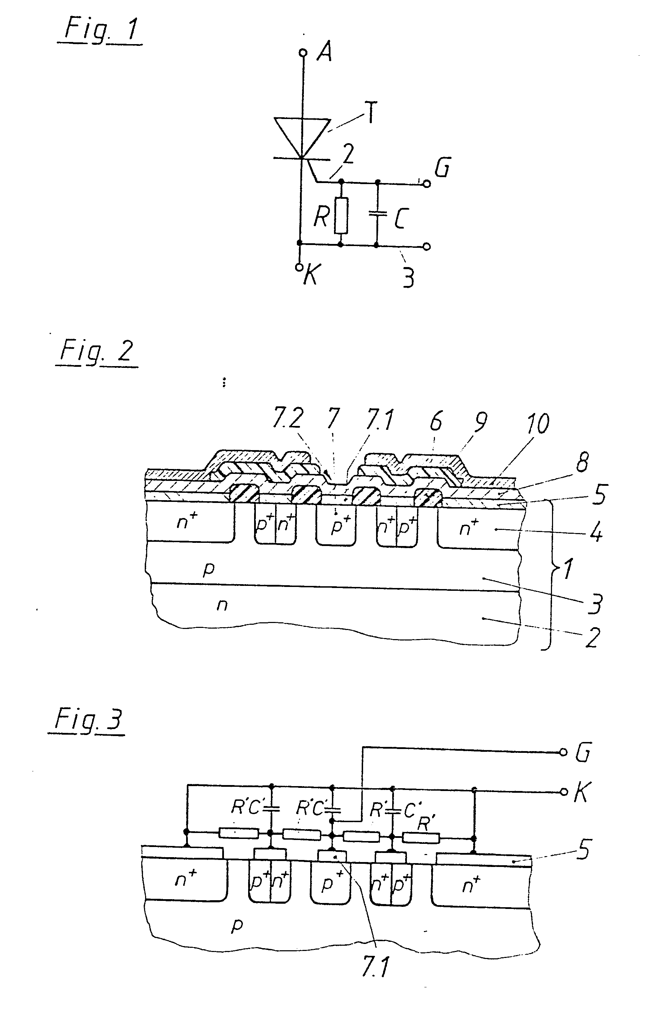

In Fig. 1 erkennt man einen Thyristor T mit Anode A, Kathode K und Steuerelektrode G. Zwischen Steuerelektrode G und Kathode K ist eine Parallelschaltung aus einem Widerstand R und einem Kondensator C angeordnet. Störimpulse, die in die Leitung zur Steuerelektrode eingestreut werden, werden über dieses RC-Glied zur Kathode abgeleitet und können dabei die Steuerstrecke im Thyristor T selbst nicht beeinflussen.

Fig. 2 zeigt die Realisierung der RC-Schutzbeschaltung in Schichttechnik direkt auf dem Aktivteil eines Thyristors. Von dem nur als Ausschnitt dargestellten Thyristoraktivteil 1 ist nur eine n-dotierte Zone 2, eine p-dotierte Zone 3 sowie mehrere $n^+$- und $p^+$-dotierte Zonen zu erkennen, wovon die außen liegende $n^+$-dotierte Zone 4 die Kathode, die im Zentrum liegende $p^+$-dotierte Zone 7 die Steuerelektrode bilden. Man erkennt weiterhin eine Kathodemetallisierung 5 sowie eine Steuerelektroden-Metallisierung 7.1. Die Metallisierungen 5, 7.1 und weitere Metallisierungen sind mit Hilfe von Isolierschichten 6 gegeneinander abgegrenzt. Diese Isolierschichten 6 schützen gleichzeitig die an die Oberfläche des Thyristoraktivteils 1 tretenden pn-Übergänge. Auf die Oberseite des Thyristoraktivteils 1 ist im Gatebereich eine dünne Metallschicht 8 aufge-

bracht, die sämtliche Metallisierungen 5,7,7.1 verbindet. Diese Metallisierung 8 ist so dünn und aus einem solchen Material, das sich zwischen der Metallisierung 7.1 der Steuerelektrode und der Metallisierung 5 der Kathode der gewünschte Widerstandswert einstellt. Auf diese Widerstandsschicht 8 ist eine Isolierschicht 9 und darauf eine Metallschicht 10 aufgebracht. Im Bereich der Steuerelektrode bilden die Isolierschicht 9 und die Gegenelektrodenschicht 10 eine Öffnung 7.2, durch die die Steuerelektrode kontaktiert werden kann. Im Kathodenbereich liegen Widerstandsschicht 8 und Gegenelektrodenschicht 10 unmittelbar aufeinander, so daß die Gegenelektrodenschicht 10 Kathodenpotential annimmt.

Fig. 3 zeigt schematisch und in zweidimensionaler Darstellung die Verteilung der Widerstände und Kondensatoren bei einer Anordnung gemäß der Fig. 2. Man erkennt, daß vom Kathodenanschluß K ein unmittelbarer Kontakt zu der Kathodenmetallisierung 5 besteht, während zu der Metallisierung 7.1 der Steuerelektrode eine Kapazität C' erscheint. Von der Metallisierung 7.1 der Steuerelektrode G erstrecken sich Widerstände R' zur Metallisierung 5 der Kathode K. Es ergibt sich somit die gewünschte Parallelschaltung von Widerstand und Kondensator zwischen Steuerelektrode G und Kathode K.

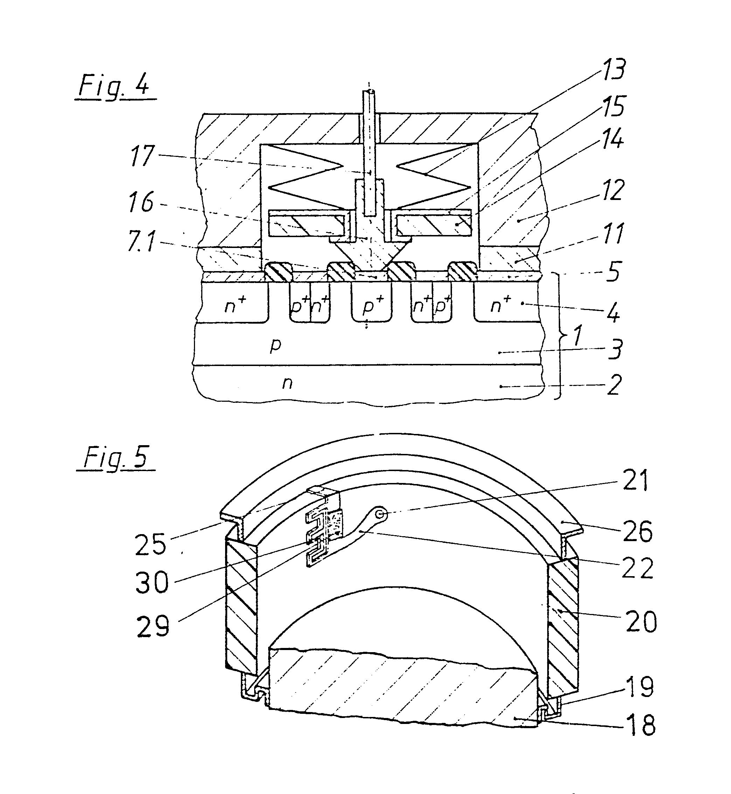

Bei dem Ausführungsbeispiel der Fig. 4 ist die Kathodenmetallisierung 5 über eine Silberplatte 11 und eine Molybdän-Druckplatte 12 in herkömmlicher Weise kontaktiert. Die Metallisierung 7.1 der Steuerelektrode ist über einen Druckkontakt 16 kontaktiert. Auf den als Kopfdraht ausgebildeten Druckkontakt 16 ist eine Keramikscheibe 14 aufgelegt, die mit einem Schichtschaltkreis 15 versehen ist. Dieser Schichtschaltkreis 15 bildet das gewünschte RC-Glied. Einzelheiten dieses Schichtschaltkreises sind in dem Schnitt nicht dargestellt. Zur mechanischen Befestigung und Kontaktierung des Schichtschaltkreises 15 dienen die Tellerfedern 13 des Gate-

druckkontaktsystems, die zwischen die Molybdän-Druckplatte 12 und die Keramikplatte 14 eingespannt sind. Von dem Druckkontakt 16 führt eine Leitung 17 zum Steuerelektrodenanschluß am Thyristorgehäuse.

In Fig. 5 erkennt man die RC-Schutzbeschaltung, die als Schichtschaltkreis direkt auf die Innenwand des Thyristorgehäuses 20 aufgebracht ist. Vom Anschluß 21 der Steuerelektrode führt eine Leiterbahn 22 zum einen Ende eines mäanderförmigen Widerstandes 30 mit parallelgeschaltetem Kondensator 29. Vom anderen Ende des Widerstandes 30 führt eine weitere Leiterbahn 25 zu einem Flansch 26, der später mit der Kathode verbunden wird. Man erkennt weiterhin eine anodenseitige Kupferronde 18, die über einen Anodenflansch 19 mit dem Keramikgehäuse 20 verbunden ist.

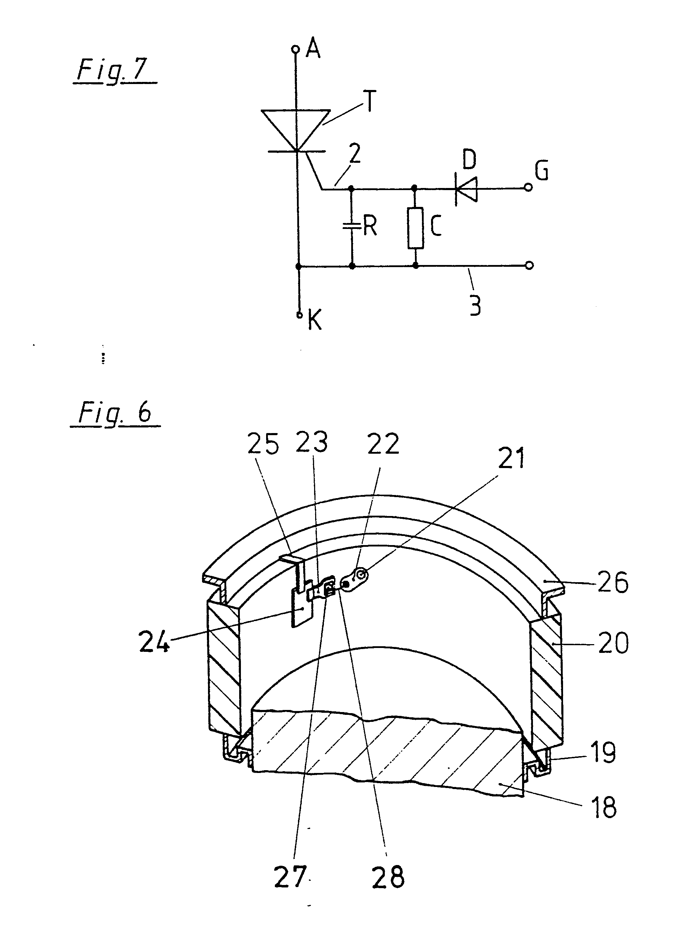

Fig. 6 zeigt eine Ausführungsform, bei der das RC-Glied auf einem getrennten Keramikplättchen 24 hergestellt und auf die Innenseite des Thyristorgehäuses 20 aufgeklebt ist. Die Verbindung zum Kathodenflansch 26 stellt die Leiterbahn 25 her. Zwischen Anschluß 21 für die Steuerelektrode und dem RC-Glied 24 ist eine Schutzdiode in Form eines Diodenchips 27 geschaltet. Die Verbindung zwischen Diodenchip 27 und Steuerelektrode 21 wird durch eine auf die Innenseite des Thyristorgehäuses 20 aufgedruckte Leiterbahn 22 und einen Kontaktierungsdraht 28 hergestellt. Die Verbindung zwischen Diodenchip 27 und RC-Glied 24 wird durch ein Metallblech 23 gewährleistet.

In Fig. 7 erkennt man den Thyristor T mit Anode A, Kathode K und Steuerelektrode G sowie der Parallelschaltung aus Widerstand R und Kondensator C zwischen Steuerelektrode G und Kathode K. Zusätzlich ist in die Leitung 2 zur Steuerelektrode eine Beschaltungsdiode D eingefügt. Es ist möglich, diese Diode D mit umgekehrter Polarität in die Leitung 3 einzufügen.

692/78

0012846.
19. 12. 1978
ZFE/P3-Bi/dr

## Ansprüche

1. Thyristor mit Anode, Kathode und Steuerelektrode und einer Schutzbeschaltung zwischen Steuerelektrode und Kathode, dadurch gekennzeichnet, daß die Schutzbeschaltung (R, C) oder (R, C, D) in den Thyristor (T) integriert ist.

2. Thyristor nach Anspruch 1, dadurch gekennzeichnet, daß die Schutzbeschaltung (R, C) im Bereich der Steuerelektrode (G) auf dem Thyristoraktivteil (1) integriert ist.

3. Thyristor nach Anspruch 2, dadurch gekennzeichnet, daß eine Metallschicht (8) im Bereich der Steuerelektrode (7.1) auf den Thyristoraktivteil (1) aufgebracht ist.

4. Thyristor nach Anspruch 2 oder 3, dadurch gekennzeichnet, daß die Metallschicht (8) streifenförmig ausgebildet ist.

5. Thyristor nach Anspruch 2, 3 oder 4, dadurch gekennzeichnet, daß die Metallschicht (8) partiell geätzt ist.

6. Thyristor nach wenigstens einem der Ansprüche 2 bis 5, dadurch gekennzeichnet, daß die Metallschicht (8) aus einer im Vakuum aufgebrachten Chromschicht mit einer Dicke zwischen ca. 10 und ca. 500 nm besteht.

7. Thyristor nach wenigstens einem der Ansprüche 2 bis 6, dadurch gekennzeichnet, daß auf der Metallschicht (8) eine Isolierschicht (9) und darüber eine weitere Metallschicht (10) aufgebracht ist.

8. Thyristor nach Anspruch 1, dadurch gekennzeichnet, daß die Schutzbeschaltung (R,C) als Schichtschaltkreis (15) auf einem Keramikplättchen (14) ausgebildet ist, welches in die Kontaktplatte (12) des Thyristoraktivteils (1) eingebaut ist.

9. Thyristor nach Anspruch 8, dadurch gekennzeichnet, daß der Schichtschaltkreis (15) durch einen Steuerelektroden-Druckkontakt (16) mit der Steuerelektrode (G) und durch Federn (13) und Kontaktplatte (11) mit der Kathode (K) verbunden ist.

10. Thyristor nach Anspruch 1, dadurch gekennzeichnet, daß die Schutzbeschaltung (R, C) als Schichtschaltkreis auf einem Keramikplättchen (24) ausgebildet ist, welches an dem Thyristorgehäuse (20) im Bereich des inneren Steueranschlusses (21) befestigt und mit den Anschlüssen (23,25) kontaktiert ist.

11. Thyristor nach Anspruch 1, dadurch gekennzeichnet, daß die Schutzbeschaltung (R, C) als Schichtschaltkreis (29,30) direkt auf der Innenwand des Keramikgehäuses (20) aufgebracht ist.

12. Thyristor nach wenigstens einem der Ansprüche 1, 2, 8, 9, 10 oder 11, dadurch gekennzeichnet, daß die Schutzbeschaltung (R, C) aus einem RC-Glied und einer Diode (D) besteht, die als Chip (27) zusätzlich an der Innenwand des Gehäuses (20) in der Nähe des Steueranschlusses (21) angebracht ist und mit dieser und dem RC-Glied in entsprechender Weise elektrisch verbunden ist.

_Fig. 1_

_Fig. 2_

_Fig. 3_

_Fig. 4_

13
15
14
12
11
5

17
16
7.1

$n^+$ | $p^+$ $n^+$ | $p^+$ | $n^+$ $p^+$ | $n^+$

4

$p$

3

$n$

2

1

_Fig. 5_

21
26
22
20

25
30
29

19
18

0012846

3/3

*Fig.7*

*Fig. 6*

## Europäisches Patentamt

# EUROPÄISCHER RECHERCHENBERICHT

| | EINSCHLÄGIGE DOKUMENTE | | KLASSIFIKATION DER ANMELDUNG (Int.Cl.³) |
|---|---|---|---|
| Kategorie | Kennzeichnung des Dokuments mit Angabe, soweit erforderlich, der maßgeblichen Teile | betrifft Anspruch | |
| | ELECTRONICS, Band 37, Nr. 21, 27. Juli 1964, Seiten 68-71 New York, U.S.A. J.M. GAULT et al.: "Stray signals can't throw this desensitized switch" <br> * Seite 69, Spalte 1, Absätze 2-4; Seite 69, Figuren A-C * <br> -- | | H 01 L 29/743 <br> 23/56 <br> H 02 M 1/08 |
| | US - A - 4 053 922 (GENERAL ELEC-TRIC CY.) <br> * Spalte 4, Zeilen 31-35; Spalte 4, Zeilen 49-51; Ansprüche 1,2, 4-6,10 * <br> & DE - A - 2 722 517 <br> -- | 1,2 | |
| | | | RECHERCHIERTE SACHGEBIETE (Int. Cl.³) |
| A | FR - A - 1 401 959 (SIEMENS) <br> * Seite 3, Spalte 1, Absätze 4, 5; Zusammenfassung 1-3 * <br> & CH - A - 406 439 <br> -- | 1,3,10 | H 01 L 29/743 <br> 23/56 <br> H 02 M 1/58 |
| A | US - A - 3 671 793 (I.T.T.) <br> * Spalte 4, Zeilen 58-75; Figur 6 * <br> & DE - A - 2 044 975 <br> -- | 3,7 | |
| | US - A - 3 445 687 (INTERNATIONAL RECTIFIER CORP.) <br> * Anspruch 1; Figuren 2-4 * <br> -- | 1,10 | |
| A | DE - A - 2 431 022 (MITSUBISHI DENKI) <br> ./. | 1 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt

| Recherchenort | Abschlußdatum der Recherche | Prüfer |
|---|---|---|
| Den Haag | 28-03-1980 | VANCRAEYNEST |

Europäisches
Patentamt

## EUROPÄISCHER RECHERCHENBERICHT

| | EINSCHLÄGIGE DOKUMENTE | | KLASSIFIKATION DER ANMELDUNG (Int.Cl ³) |
|---|---|---|---|
| Kategorie | Kennzeichnung des Dokuments mit Angabe, soweit erforderlich, der maßgeblichen Teile | betrifft Anspruch | |
| | * Seite 4, Absatz 2 * | | |
| | -- | | |
| A | DE - A - 2 060 854 (SIEMENS) | 1,12 | |
| | * Figur 12 * | | |
| | ---- | | |

RECHERCHIERTE SACHGEBIETE (Int. Cl. ³)